(19) **Europäisches Patentamt**

**European Patent Office**

**Office européen des brevets**

(11) **EP 1 117 182 A1**

(12) **EUROPEAN PATENT APPLICATION**

(43) Date of publication:
**18.07.2001 Bulletin 2001/29**

(51) Int Cl.⁷: **H03L 7/08**

(21) Application number: **00100428.2**

(22) Date of filing: **10.01.2000**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI** | (71) Applicant: **SIEMENS AKTIENGESELLSCHAFT**<br>**80333 München (DE)**<br><br>(72) Inventor: **Soerensen, Henrik**<br>**9530 Stovring (DK)** |

(54) **Phase locked loop**

(57)     The invention relates to a phase locked loop (1) which allows better noise rejection. The phase locked loop (1) comprises a phase detector (5), a loop filter (10), and a voltage controlled oscillator (15). A balanced signal transmission is realized between the phase detector (5) and the loop filter (10) and/or between the loop filter (10) and the voltage controlled oscillator (15). The balanced signal transmission may be realized by two drive lines (20, 25; 30, 35) which are guided close to each other and having essentially the same length.

Fig.1

EP 1 117 182 A1

## Description

Prior art

The invention proceeds from a phase locked loop in accordance with the generic class of the independent patent claim.

From the National Semiconductor Application Note 885, Cynthia L. Barker, Wireless Communications, March 1993, a phase locked loop comprising a phase detector, a loop filter, and a voltage controlled oscillator is already known.

From the Texas Instruments Data Transmission Semi NTR Manual, 1996, page 6-2, balanced interface circuits are already known, whereby balanced interface circuits consist of a generator with differential outputs and a receiver with differential inputs. Under the assumption that any noise is coupled into both wires of the transmission line in the same way, the noise voltage difference between these two wires will be always zero. Due to the common mode rejection capability of a differential amplifier, this noise will be rejected.

Advantages of the invention

The phase locked loop having the characterizing features of the independent patent claim has the advantage that a balanced signal transmission between the phase detector and the loop filter and/or between the loop filter and the voltage controlled oscillator is provided. On this way, low-frequency common-mode noise coupled into the signal path from the phase detector to the voltage controlled oscillator and/or high-frequency noise radiated into the signal path from the loop filter to the voltage controlled oscillator may be essentially eliminated, therefore providing improved noise rejection of the phase locked loop to external low-and high-frequency noise, e.g. supply voltage variations. Supply voltage may be lowered without sacrificing the purity of the PLL output signal, and the noise rejection capability of the PLL. Thus, supply power and/or voltage conversion circuitry may be saved. This makes the use of a phase locked loop according to the invention more practical especially in battery powered mobile phones and other portable radio communications equipment.

The features of the dependent patent claims enable further improvement of the invention.

It is very important to realize the balanced signal transmission by two drive lines which are guided close to each other and having essentially the same length. In this manner, it may be essentially guaranteed, that the noise coupled into the balanced signal transmission will be essentially the same on both drive lines such that it can easily be eliminated using a suitable differential or subtraction process at the signal reception.

A very exact realization of the two drive lines to fulfill the described requirements may be achieved by realizing the two drive lines as striplines or microstrips on a printed circuit board whereby the realization process may be controlled by a computer.

Another more suitable solution consists in having different drive voltages especially of the same sign on both drive lines. Noise can also be easily eliminated by only subtracting the signals received from the two drive lines, whereby the control signals themselves are not eliminated because different drive voltages are used on both drive lines. If only drive voltages of the same sign are used, a power supply of only one sign is necessary for the phase locked loop. If for example only positive drive voltages on both lines are used, only a positive supply voltage for the phase locked loop is required.

It is also possible that the drive voltage of each drive line is the negative of the drive voltage of the other drive line. On this way, noise may easily be eliminated by subtracting the signals received from the two drive lines, whereby the control signals themselves will be doubled.

The use of a charge pump is also very advantageous to amplify the output signal of the phase detector to a required signal level used to control the voltage controlled oscillator.

Drawings

Examples of the invention are shown in the figures and explained in greater detail in the description below. Figure 1 shows a block diagram of a phase locked loop according to the invention, figure 2 shows the realization of balanced drive lines as striplines on a printed circuit board, figure 3 shows the realization of balanced drive lines as microstrips embedded into a printed circuit board, figure 4 shows a realization of balanced drive lines as a twisted pair cable, figure 5 shows a first realization example of a single-ended loop filter and figure 6 shows a second realization example of a balanced loop filter.

Description

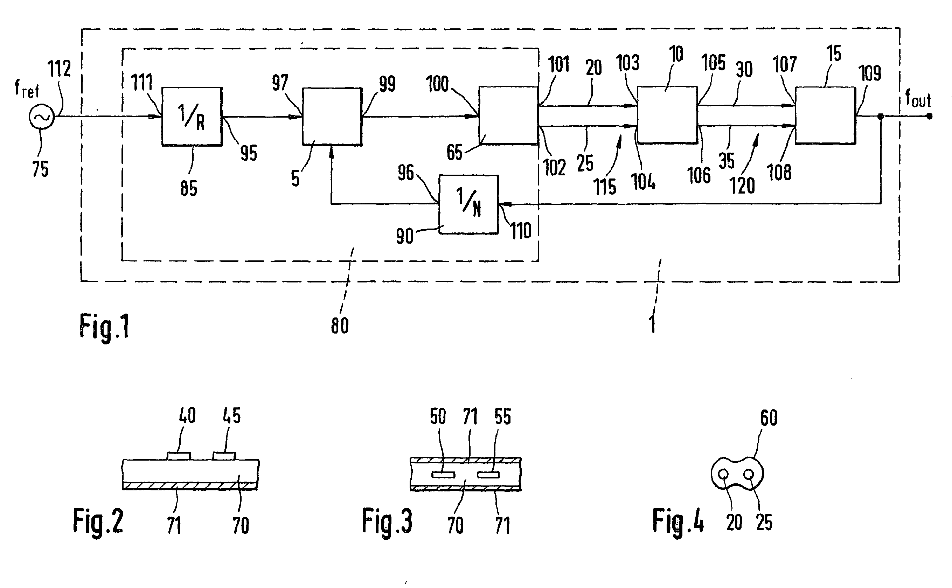

In figure 1, numeral 1 designates a phase locked loop. Phase locked loops may be used for many radio applications including frequency synthesizers, carrier recovery and clock recovery circuits, tunable filters, frequency multipliers, receiver demodulators, and modulators. The described example is related to a phase locked loop as a frequency synthesizer. There are two main reasons for using a phase locked loop as a frequency synthesizer. One is to translate the frequency accuracy of a high quality signal source to a tunable signal source. The second is to translate the noise characteristics of a high quality signal source to a lower quality signal source. The block diagram example of a basic phase locked loop is shown in figure 1. The high quality signal source, in this case, is a crystal reference oscillator 75. The phase locked loop 1 comprises a synthesizer integrated circuit 80. The synthesizer integrated circuit 80 comprises a reference frequency devider 85, a main frequency divider 90, a phase detector 5, and a charge pump 65. An output 112 of the crystal reference oscillator 75 is connected to an input 111 of the reference frequency divider 85. An output 95 of the reference frequency divider 85 is connected to a first input 97 of the phase detector 5. An output 99 of the phase detector 5 is connected to an input 100 of the charge pump 65. A first output 101 of the charge pump 65 is connected via a first drive line 20 to a first input 103 of a loop filter 10. A second output 102 of the charge pump 65 is connected via a second drive line 25 to a second input 104 of the loop filter 10. A first output 105 of the loop filter 10 is connected via a third drive line 30 to a first input 107 of a voltage controlled oscillator 15. A second output 106 of the loop filter 10 is connected via a fourth drive line 35 to a second input 108 of the voltage controlled oscillator 15. An output 109 of the voltage controlled oscillator 15 is connected to an input 110 of the main frequency divider 90. An output 96 of the main frequency divider 90 is connected to a second input 98 of the phase detector 5.

The crystal reference oscillator 75 provides a reference signal at a very clean and exact reference signal frequency $f_{ref}$. In the synthesizer integrated circuit 80, the reference signal frequency $f_{ref}$ is divided by a first integer R at the reference frequency divider 85. An output frequency $f_{out}$ of an output radio frequency signal at the output 109 of the voltage controlled oscillator 15 is divided by a second integer N at the main frequency divider 90. The reference signal frequency $f_{ref}$ divided by the first integer R and the output frequency $f_{out}$ divided by the second integer N are compared by the phase detector 5. The phase detector 5 controls the charge pump 65, which generates a control signal. The control signal is filtered in the loop filter 10. The filtered control signal is then provided to the voltage controlled oscillator 15 to control the output frequency $f_{out}$ and phase at the output 109 of the voltage controlled oscillator 15. The design of the loop filter 10 involves a trade off between the output signal purity at the output 109 of the voltage controlled oscillator 15 affected by sidebands of the reference signal from the crystal reference oscillator 75 as well as by noise around the output frequency $f_{out}$ and the switching time of the phase locked loop 1 necessary to lock. The loop filter 10 must be designed for the correct balance between the above mentioned output signal purity and the required lock time for the phase locked loop 1. Generally, the narrower the loop bandwidth of the loop filter 10 the better the output signal purity but the longer the lock time. The function of the above described phase locked loop 1 is described in more detail in "National Semiconductor Application Note 885", Wireless Communications, March 1993.

Usually, the phase locked loop 1 must span a certain frequency range which can be selected by varying the second integer N of the main frequency divider 90. Depending on the supply voltage of the phase locked loop 1, an important demand on the voltage control oscillator 15 can be calculated, namely the control voltage sensitivity CVS. The CVS is calculated as follows:

$$\text{CVS} = \text{Frequency range } \Delta f / \text{supply voltage range } \Delta U.$$

With a frequency range from 1000-1100 MHz or $\Delta f = 100$ MHz and a supply voltage range of $\Delta U = 5V$, the control voltage sensitivity CVS is 20 MHz/V. A guard band is often added at each end of the frequency range $\Delta f$ as well as a guard voltage is subtracted at each end of the supply voltage range $\Delta U$ to account for component tolerances and loop switching overshoot. With 10 MHz guard band at each end of the frequency range $\Delta f$ and 0,5 V guard voltage at each end of the supply voltage range $\Delta U$, a modified frequency range $\Delta f$ of 120 MHz and a modified supply voltage range $\Delta U$ of 5-1 = 4 V results and the control voltage sensitivity CVS becomes 30 MHz/V. If the supply voltage range $\Delta U$ is further reduced to 3 - 1 = 2 V, the control voltage sensitivity CVS becomes 60 MHz/V. Generally, the higher the control voltage sensitivity CVS of the voltage controlled oscillator 15, the more sensitive is the phase locked loop 1 to external low-or high-frequency noise. Values considerably above 60 MHz/V for the CVS are generally considered quite high, corresponding to a high sensitivity of the phase locked loop 1 to external noise. The loop filter 10 rejects the high-frequency contents of the control signal provided by the charge pump 65 but allows low-frequency contents of this control signal to pass. As a result, any low-frequency noise which is present on the signal path from the charge pump 65 to the voltage controlled oscillator 15 degrades the performance of the phase locked loop 1 causing noise on the output 109 of the voltage controlled oscillator 15. Also, high-frequency noise radiated into the signal path from the loop filter 10 to the voltage controlled oscillator 15 may degrade the performance of the phase locked loop 1, independent of the efficiency of the loop filter 10.

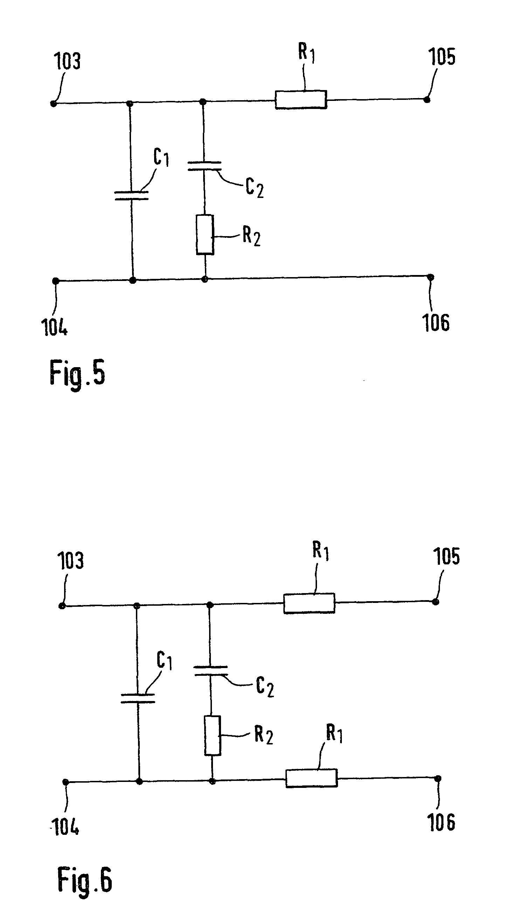

According to the invention, a balanced signal transmission is realized between the charge pump 65 and the loop filter 10 as well as between the loop filter 10 and the voltage controlled oscillator 15. The balanced signal transmission between the charge pump 65 and the loop filter 10 is realized by the first drive line 20 and the second drive line 25 and the balanced signal transmission between the loop filter 10 and the voltage controlled oscillator 15 is realized by the third drive line 30 and the fourth drive line 35. The first drive line 20 and the second drive line 25 are guided close to each other and have essentially the same length. Also the third drive line 30 and the fourth drive line 35 are guided close to each other and have essentially the same length. The balanced signal transmission between the charge pump 65 and the loop filter 10 as well as the balanced signal transmission between the loop filter 10 and the voltage controlled oscillator 15 is driven by direct current (DC). A realization for such a generic driver/receiver pair generating a direct current driven balanced signal transmission is for example known from "Timing Solutions - low skew clock drivers and clock generation circuits", Motorola BR 1333/D, September 1993, page 27, figure 6. Therefore, the control signal pulses provided from the charge pump 65 are transmitted to the loop filter 10 on the first drive line 20 at a first pulse amplitude corresponding to the first drive voltage and on the second drive line 25 at a second pulse amplitude corresponding to a second drive voltage. Smoothened control signal pulses are then transmitted from the loop filter 10 to the voltage controlled oscillator 15 on the third drive line 30 at a third pulse amplitude corresponding to a third drive voltage and on the fourth drive line 35 at a fourth pulse amplitude corresponding to a fourth drive voltage. The first drive voltage and the third drive voltage may in this example but not necessarily be essentially equal as well as the second drive voltage and the fourth drive voltage.

The voltages on the first input 103 and the second input 104 of the loop filter 10 will be subtracted from each other as well as the voltages at the first input 107 and the second input 108 of the voltage controlled oscillator 15. It is also possible to use a single ended low-pass filter according to figure 5 or a balanced low-pass filter according to figure 6 for the loop-filter 10, so that no subtraction happens at the loop-filter 10. The single ended low-pass filter according to the example of figure 5 consists of a first resistance $R_1$ between the first input 103 and the first output 105 of the loop filter 10 and a first capacitance $C_1$ between the first input 103 and the second input 104, whereby the second input 104 is directly connected to the second output 106 of the loop filter 10 and representing the ground potential. Parallel to the first capacitance $C_1$ is provided a second capacitance $C_2$ in serial connection to a second resistance $R_2$.

The balanced low-pass filter according to the example of figure 6 corresponds to the single ended low-pass filter according to figure 5 with the difference that the second input 104 and the second output 106 are also connected via the first resistance $R_1$.

In the case of the use of a single ended low-pass filter or a balanced low-pass filter for the loop filter 10, voltage subtraction is only realized at the voltage controlled oscillator 15. Therefore, the charge pump 65 and the loop filter 10 represent a first generic driver/receiver pair and the loop filter 10 together with the voltage controlled oscillator 15 represent a second generic driver/receiver pair according to the cited article "Timing Solutions - low skew clock drivers and clock generation circuits", Motorola BR 1333/D. The differential control signal pulses at the loop filter 10 will be smoothened for the transmission to the voltage controlled oscillator 15 and the subtracted or differential smoothened control signal pulses at the voltage controlled oscillator 15 will be used to control the corresponding output frequency $f_{out}$. The first and the second drive line 20, 25 represent a first transmission line 115 and the third drive line 30 and the fourth drive line 35 represent a second transmission line 120. Under the assumption that any noise is coupled in the same way into the two drive lines 20, 25 of the first transmission line 115 or into the two drive lines 30, 35 of the second transmission line 120, the noise difference between the two drive lines 20, 25 of the first transmission line 115 and the noise difference between the two drive lines 30, 35 of the second transmission line 120 will essentially be zero. Supposing that the two drive lines of each transmission line are arranged sufficiently close to each other and having approximately the same length, noise of exactly the same magnitude and phase, so called common-mode noise, is impressed on both drive lines of the corresponding transmission line and therefore may be essentially canceled. Therefore, noise rejection between the charge pump 65 and the voltage controlled oscillator 15 is improved considerably. Consequently, the phase locked loop 1 is less sensitive to external low- and high-frequency noise. A high control voltage sensitivity CVS of the voltage controlled oscillator 15 may therefore be realized without causing considerable sensitivity to external low- or high-frequency noise. A high control voltage sensitivity CVS is typically required at low supply voltages. Therefore, the supply voltage and thus supply power for the phase locked loop 1 may be reduced.

In the following, two examples for the selection of drive voltages for the two drive lines of the corresponding transmission line are described. In a first example, the drive voltage of each drive line is the negative of the drive voltage of the adjacent drive line of the same transmission line. This requires a positive and a negative power supply for the phase locked loop 1. The amount of the differential control signal amplitude at the loop filter 10 or at the voltage controlled oscillator 15 equals then two times the amplitude of each control signal, i.e. the drive voltage on each drive line of the corresponding transmission line, whereas the superimposed noise on each drive line of the corresponding transmission line will be essentially eliminated. The differential amplitude of the pulse train at the loop filter 10 or of the smoothened pulse train at the voltage controlled oscillator 15 therefore will be doubled in comparison with the pulse train amplitude on each preceding drive line.

According to another example of the invention, it is already sufficient to provide drive voltages for adjacent drive lines with different sign and magnitude. The differential amplitude thereby will be the sum of the amounts of the corresponding drive voltages and the superimposed noise will also be eliminated as described above.

Another often more suitable solution consists in different drive voltages of only one sign on both drive lines of a transmission line which lie. especially in a predetermined range of drive voltages. Again, the difference between the control signal pulses of the two drive lines of a transmission line is the actual or effective control signal for the voltage controlled oscillator 15. For example, only positive drive voltages are selected for both drive lines of each transmission line. This requires only positive supply voltages for the phase locked loop 1. The drive voltages of the drive lines of a transmission line should be selected with different magnitudes to prevent canceling of the control signal pulses when subtracting the received control signal pulses at the loop filter 10 or at the voltage controlled oscillator 15. The superimposed noise on each drive line of the corresponding transmission line will be eliminated.

The two drive lines of a transmission line may be realized as striplines 40, 45 on a printed circuit board 70 based on an especially metallic ground layer 71 according to figure 2, as microstrips 50, 55 embedded into a printed circuit board 70 sandwiched between two especially metallic ground layers 71 according to figure 3 or as a twisted pair cable 60 according to figure 4, which shows an example for the first drive line 20 and the second drive line 25 as parts of the twisted pair cable 60.

Noise elimination is achieved when the balanced signal transmission is realized either between the charge pump 65 and the loop filter 10 and between the loop filter 10 and the voltage controlled oscillator 15. It is also in the scope of the invention, to provide only balanced signal transmission between the charge pump 65 and the loop filter 10 or only between the loop filter 10 and the voltage controlled oscillator 15. As the charge pump 65 may be part of the phase detector 5, a balanced signal transmission as described above may be installed between the phase detector 5 and the loop filter 10. Generally, a balanced signal transmission as described above may be installed between the phase detector 5 and the loop filter 10 even for the case, the charge pump 65 is not used in the phase locked loop 1. The noise on both drive lines of each transmission line is independent of the utilized drive voltages for the both drive lines. The phase locked loop 1 according to the invention may for example be used in a mobile phone or another telecommunications device.

**Claims**

1. Phase locked loop (1) comprising a phase detector (5), a loop filter (10) and a voltage controlled oscillator (15), **characterized by** a balanced signal transmission between the phase detector (5) and the loop filter (10) and/or between the loop filter (10) and the voltage controlled oscillator (15).

2. Phase locked loop (1) according to claim 1, characterized in that the balanced signal transmission is realized by two drive lines (20, 25; 30, 35) which are guided close to each other and having essentially the same length.

3. Phase locked loop (1) according to claim 2, characterized in that the two drive lines (20, 25; 30, 35) are realized as striplines (40, 45) or microstrips (50, 55) on a printed circuit board (70).

4. Phase locked loop (1) according to claim 2 or 3, characterized in that the two drive lines are realized as a twisted pair cable (60).

5. Phase locked loop (1) according to anyone of the preceding claims, characterized in that the balanced signal transmission is driven by direct current.

6. Phase locked loop (1) according to anyone of claims 1 to 5, characterized in the use of different drive voltages on both drive lines (20, 25; 30, 35), the different drive voltages having especially the same sign.

7. Phase locked loop (1) according to anyone of the preceding claims, characterized in that the drive voltage of each drive line (20, 25; 30, 35) is the negative of the drive voltage of the other drive line (20, 25; 30, 35).

8. Phase locked loop (1) according to anyone of the preceding claims, characterized in that the phase detector (5) is connected to the loop filter (10) via a charge pump (65).

9. Phase locked loop (1) according to claim 8, characterized in a balanced signal transmission between the charge pump (65) and the loop filter (10).

Fig.1

Fig.2

Fig.3

Fig.4

103    R₁    105

C₁    C₂    R₂

104    106

**Fig.5**

103    R₁    105

C₁    C₂    R₂    R₁

104    106

**Fig.6**

EP 1 117 182 A1

## DOCUMENTS CONSIDERED TO BE RELEVANT

**European Patent Office**

**EUROPEAN SEARCH REPORT**

Application Number

EP 00 10 0428

| Category | Citation of document with indication, where appropriate, of relevant passages | Relevant to claim | CLASSIFICATION OF THE APPLICATION (Int.Cl.7) |
|---|---|---|---|
| X | US 6 011 822 A (DREYER STEPHEN F) 4 January 2000 (2000-01-04) * column 5, line 31 - column 10, line 30 * * column 9, line 45 - line 54 * * column 12, line 4 - column 13, line 30 * * column 14, line 19 - line 63 * * figures 1-9,12,15 * | 1-3,5-9 | H03L7/08 |
| X | US 5 663 689 A (PHILPOTT RICK A ET AL) 2 September 1997 (1997-09-02) * column 3, line 42 - column 6, line 20; figures 1-5 * | 1-3,5-9 | |
| X | EP 0 674 392 A (DISCOVISION ASS) 27 September 1995 (1995-09-27) * column 2, line 33 - column 6, line 3; figures 1-3 * | 1-3,5-9 | |
| X | US 5 422 603 A (SOYUER MEHMET) 6 June 1995 (1995-06-06) * column 1, line 37 - line 59 * * column 2, line 15 - column 5, line 41; figure 1 * | 1-3,5-9 | TECHNICAL FIELDS SEARCHED (Int.Cl.7) H03L |
| X | "COMMON-MODE FEEDBACK CIRCUIT FOR FULLY DIFFERENTIAL CMOS CIRCUITS" IBM TECHNICAL DISCLOSURE BULLETIN,US,IBM CORP. NEW YORK, vol. 38, no. 8, 1 August 1995 (1995-08-01), pages 435-437, XP000534582 ISSN: 0018-8689 * the whole document * | 1-3,5-9 | |

The present search report has been drawn up for all claims

| Place of search | Date of completion of the search | Examiner |
|---|---|---|
| THE HAGUE | 8 June 2000 | Balbinot, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

8

EP 1 117 182 A1

**ANNEX TO THE EUROPEAN SEARCH REPORT
ON EUROPEAN PATENT APPLICATION NO.** EP 00 10 0428

This annex lists the patent family members relating to the patent documents cited in the above-mentioned European search report.
The members are as contained in the European Patent Office EDP file on
The European Patent Office is in no way liable for these particulars which are merely given for the purpose of information.

08-06-2000

| Patent document cited in search report | | Publication date | Patent family member(s) | | Publication date |
|---|---|---|---|---|---|
| US 6011822 | A | 04-01-2000 | US | 5740213 A | 14-04-1998 |
| US 5663689 | A | 02-09-1997 | NONE | | |
| EP 0674392 | A | 27-09-1995 | AT | 183862 T | 15-09-1999 |
| | | | CA | 2143017 A | 25-09-1995 |
| | | | CN | 1126394 A | 10-07-1996 |
| | | | DE | 69511605 D | 30-09-1999 |
| | | | DE | 69511605 T | 06-04-2000 |
| | | | JP | 2990647 B | 13-12-1999 |
| | | | JP | 7297710 A | 10-11-1995 |
| | | | US | 5677648 A | 14-10-1997 |
| US 5422603 | A | 06-06-1995 | NONE | | |

EPO FORM P0459

For more details about this annex : see Official Journal of the European Patent Office, No. 12/82